# EUROPEAN PATENT APPLICATION

(11) **EP 4 844 944 A1**
(43) Date of publication of application: **25.11.2026**
(21) Application number: 25178261.1
(22) Date of filing: 22.05.2025
(51) Int. Cl.: H01P 5/107, H01Q 1/22, G01S 7/02, H01L 25/00

(54) **LAUNCHER-IN-PACKAGE DEVICE STRUCTURE**

(71) Applicant: NXP B.V., 5656 AG Eindhoven (NL)
(72) Inventor: BOSMA, Sjoerd, 5656AG Eindhoven (NL); van SCHELVEN, Ralph Matthijs, 5656AG Eindhoven (NL)
(74) Representative: Schwarzweller, Thomas

(57) **Abstract**

Aspects of this disclosure are directed to an LIP device, adapted to launch an RF signal from a first major surface thereof and comprising: a stack including a plurality of metal layers having dielectric material therebetween; wherein the plurality of metal layers comprises, in a launcher region: a first planar metal layer comprising a continuous layer configured as a backing reflector layer; a second planar metal layer being discontinuous and comprising a plurality of isolated metal patches in an array and having insulating material therebetween; and a third planar metal layer having an aperture therein, and a patterned metal antenna within the aperture and configured for launching the RF signal; wherein the first planar metal layer is more remote from the first major surface than each of the second planar metal layer and the discontinuous metal layer; and an RF feed-path to the patterned metal antenna.

## Description

### FIELD OF THE DISCLOSURE

This present disclosure relates to Launcher-In-Package (LIP) devices.

### BACKGROUND

Launcher in package devices are becoming of increasing interest in several fields of semiconductor devices and systems. One such field is radar devices and systems, and in particular automotive radar, in which, typically, more than one RF signal is required to be efficiently guided from a single semiconductor device to separate, typically distributed, antennas for transmission, and reflected radar signals received by distributed antennas and guided back to a single or even the same semiconductor device.

Such LIP devices may be integral with a semiconductor die, and provide for launching an RF signal from the semiconductor die into a waveguide, such as an air-filled waveguide (AFWG) directly from a packaged semiconductor device, for example in a ball grid array (BGA) package. Alternatively, they may form part of a package assembly, in which the device, comprising for example a stack of PCBs layers, can be affixed to a packaged semiconductor die (for example a semiconductor die packaged in a BGA package). The RF signal may then be guided into the device via strip-line or microstrip, and through one or more of solder balls in the BGA, and then launched from the device into a cavity waveguide, such as an AFWG.

The mechanical and physical design of such a launcher in package device can be challenging.

### SUMMARY

According to a first aspect of the present disclosure, there is provided a launcher-in-package, LIP, device, adapted to launch an RF signal from a first major surface thereof and comprising: a stack including a plurality of metal layers having dielectric material therebetween; wherein the plurality of metal layers comprises, in a launcher region: a first planar metal layer comprising a continuous layer configured as a backing reflector layer; a second planar metal layer being discontinuous and comprising a plurality of isolated metal patches in an array and having insulating material therebetween; and a third planar metal layer having an aperture therein, and a patterned metal antenna within the aperture and configured for launching the RF signal; wherein the first planar metal layer is more remote from the first major surface than each of the second planar metal layer and the discontinuous metal layer; and an RF feed-path to the patterned metal antenna. The isolated patches may form an artificial dielectric layer. Such an artificial dielectric layer may increase the effective dielectric constant of the cavity, which is behind the launcher, and thereby increase device design flexibility. Moreover, inclusion of the isolated patches may assist in reducing or controlling shrinkage of the dielectric material, and or warpage or sagging of the first planar metal layer.

In one or more embodiments, the LIP device further comprises: one or more further planar metal layers, each being discontinuous and comprising a further plurality of isolated metal patches in an array and having dielectric material therebetween. In such embodiments, the presence of two or more layers of isolated patches may further help to reduce or eliminate sagging of the reflector layer, and may, in addition, alternatively, provide an improved artificial dielectric.

In one or more embodiments, the third planar layer is at the first major surface of the LIP device package; and the second planar layer, and where present, the or each of the second of the further planar metal layers, is between the first planar layer the third planar layer. Such embodiments are typically designed to launch RF radiation from the first major surface, and the presence of the isolated layers between the launcher and the reflective layer may enable lower profile devices through an increased effective dielectric constant.

In one or more embodiments, the isolated metal patches, and where present the or each of the second of the further isolated metal patches have a larger dimension which is not more than λ/4, where λ is a wavelength of the RF signal. By providing patches which are smaller relative to the wavelength of the RF radiation, the patches do not interfere, or interfere only to a limited extent, with the transmission of radiation.

In one or more embodiments, the isolated metal patches, and where present the or each of the second of the further isolated metal patches, are rectangular. Rectangular patches are particularly convenient for the purposes of design.

In one or more embodiments: each respective patch in the second planar metal layer is aligned with a respective patch in the or each further planar metal layers. This may assist with the transparency of the patches towards RF radiation.

In one or more embodiments the array has a respective pitch, in each of an x-direction and a y-direction, each within a range of 175µm to 250µm.

In one or more embodiments the stack further comprises, surrounding the launcher region, a plurality of conductive vias through the dielectric layers, and providing electrical connection between the metal layers and RF shielding for the launcher. The electrical connection path may include one or more of the, or additional, conductive through vias,

In one or more embodiments the patterned metal antenna comprises a slot antenna. In other embodiments, the patterned metal antenna has an alternative design, such as, without limitation, a dipole antenna.

In one or more embodiments the device is a ball-grid-array, BGA, package; the dielectric material and the insulating material is an encapsulant material; the stack forms a redistribution structure; and the RF feed-path provides electrical connection between the launcher and a semiconductor die within the BGA package.

In one or more embodiments the device is adapted to launch an RF signal from the first major surface thereof into an air-filled waveguide, AFWG.

According to a second aspect of the present disclosure, there is provided a launcher-in-package, LIP, assembly comprising the LIP device, and the AFWG.

In one or more embodiments the device forms a substrate, to which a ball-grid-array, BGA, package may be affixed on a surface opposite the first major surface; the stack is formed of a plurality of printed circuit boards, PCBs, wherein the insulating material is an adhesive material for bonding the PCBs; and the RF feed-path provides electrical connection between the launcher and a contact for connection to a solder ball of the BGA package. The substrate may alternatively be referred to as a launcher layer or launcher device, the PCB layers may be replaced by other suitable layers or structures.

In one or more embodiments, in the launcher region, the first planar metal layer has no apertures therethrough which are larger than λ/4, where λ is a or the wavelength of the RF signal.

According to a third aspect of the present disclosure, there is provided An LIP assembly, comprising: an air-filled waveguide (AFWG); and an LIP device, adapted to launch an RF signal from a first major surface thereof in to the AFWG and comprising: a stack including a plurality of metal layers having dielectric material therebetween; wherein the plurality of metal layers comprises, in a launcher region: a first planar metal layer comprising a continuous layer configured as a backing reflector layer; a second planar metal layer being discontinuous and comprising a plurality of isolated metal patches in an array and having insulating material therebetween; and a third planar metal layer having an aperture therein, and a patterned metal antenna within the aperture and configured for launching the RF signal; wherein the first planar metal layer is more remote from the first major surface than each of the second planar metal layer and the discontinuous metal layer; and an RF feed-path to the patterned metal antenna.

In one or more embodiments, the LIP assembly further comprises: one or more further planar metal layers, each being discontinuous and comprising a further plurality of isolated metal patches in an array and having dielectric material therebetween. In one or more embodiments: the third planar layer is at the first major surface of the LIP device package; and the second planar layer, is between the first planar layer the third planar layer. In one or more embodiments the isolated metal patches have a larger dimension which is not more than λ/4, where λ is a wavelength of the RF signal. In one or more embodiments the isolated metal patches are rectangular. In one or more embodiments each respective patch in the second planar metal layer is aligned with a respective patch in the or each further planar metal layers. In one or more embodiments the stack further comprises, surrounding the launcher region, a plurality of conductive vias through the dielectric layers, and providing electrical connection between the metal layers and RF shielding for the launcher.

### BRIEF DESCRIPTION OF THE DRAWINGS

Reference will now be made to the accompanying drawings, wherein:
FIG. 1 illustrates a conventional launcher in package device, launching an RF signal into a cavity waveguide;
FIG. 2 illustrates a launcher in package device, launching an RF signal into a cavity waveguide, according to one or more embodiments;
FIG. 3 illustrates a stand-alone launcher in package device according to one or more embodiments
FIG. 4 shows a view looking up at the first major surface of the LIP device of FIG. 3;
FIG. 5 shows a schematic section through an LIP device according to one or more other embodiments;
FIG. 6 shows a schematic section through an LIP device, according to one or more yet other embodiments;
FIG. 7 shows a schematic section through an LIP device, according to one or more further embodiments;
FIG. 8 shows a schematic bottom view of an LIP device according to one or more other embodiments;
FIG. 9, this shows a perspective view of four metal layers in a launch region of an LIP device;
FIG. 10 shows a simulated millimeter-wave performance of a conventional LIP device without patches;
FIG. 11, shows a simulated millimeter-wave performance of an LIP device, including patches, according to an embodiment of the present disclosure;
FIG. 12, shows an implementation of an LIP devices, according to one or more embodiments of the present disclosure;
FIG. 13, shows an implementation of another LIP devices, according to one or more embodiments of the present disclosure;

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar features in modified and different embodiments.

### DETAILED DESCRIPTION

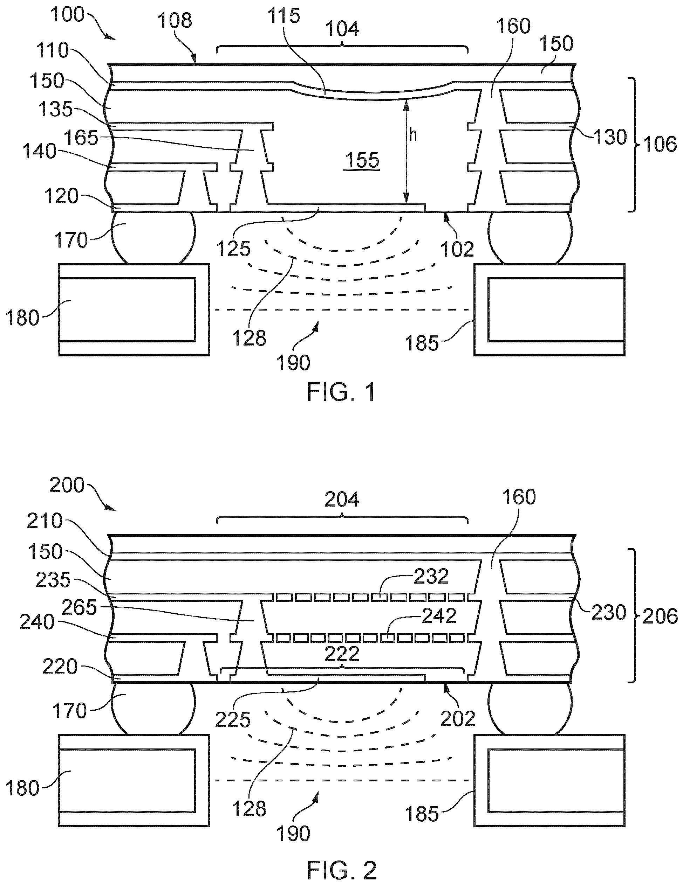

FIG. 1 illustrates a conventional launcher in package device 100, for launching an RF signal 128, pictorially illustrated as wavelets, into a cavity waveguide 190. In particular, the LIP device 100 comprises a stack 106 including a plurality of metal layers110, 120, 130, and 140 having dielectric material 150 therebetween. There may be, as shown, further dielectric material, 150 above the uppermost metal layer 110. In a launcher region 104 of the device is an antenna 125, to which a RF signal is guided by means of, for example, strip line 135 comprised in one 130 of the metal layers, together with one or more vias 165 between the metal layers and the antenna 125. The antenna 125 is at or near a first, or bottom, major surface 102 of the LIP device. In the launcher region behind the antenna (that is to say, above antenna 125 as shown in figure 1), intermediate metal layers 130 and 140 include apertures, to form a rear chamber, cavity or stub region 155 for the antenna 125. The cavity is filled with the dielectric material. The metal layer 110, which is furthest from the antenna, that is to say which is most remote from the first major surface 102 of the LIP device does not have an aperture therein, but is continuous in the launcher region 104. This metal layer 110 acts as a backing reflector layer, to prevent the RF signal from launching from the second, or top, major surface 108 of the LIP device. Rather, it reflects the radar signal to reinforce and be part of the waveguided signal 128, which is launched from the bottom, that is to say the first major surface, of the LIP device.

As shown, the LIP device 100 may be affixed, for example, by means of solder balls 170, to a waveguiding device or structure 180. The waveguiding structure 180 includes an aperture, which may typically be generally rectangular, but, as the skilled person will recognise, may have a different profile, such as oblong, circular, or dog-bone-shaped, the sides faces 185 of which are metallised to form a cavity waveguide such as an air-filled waveguide. In the example shown, the underside of the waveguiding structure 180 is open, in order to allow free propagation of the RF signal, 128 from the bottom of the device; however the skilled person will appreciate that the structure may provide further cavity waveguides such as AFWGs for example, to redirect the RF signal laterally away from the launcher.

The conventional device shown in FIG. 1 may suffer from one or both of at least two problems. Firstly, it may be difficult to ensure the planarity of the backing reflector layer 115. In particular, due to the aperture in the intermediate metal layers 130 and 140, there exists a larger volume of dielectric material in the cavity region 155 than is the case elsewhere in the device. This dielectric material may be, for example, an encapsulant material. Such materials are prone to shrinkage when they cure, and as a result, the backing reflector layer 115 may sag as shown. Control of the separation h between the antenna 125 and the backing reflector layer 115 is important for device design, and as a result, any sagging or non-planarity in the backing reflector layer may result in degradation of the performance of the launcher.

Another challenge relating to the cavity region is that of the limitation in height h. The cavity behind the launcher acts as an RF "stub", the length (corresponding this case to the height h), of which is important for RF design purposes. Although the dielectric constant of the dielectric is generally higher than air, allowing for more flexibility in design, the limited height available is still a constraint in some device applications.

FIG. 2 illustrates an LIP device 200, mounted on a waveguide structure 180 and in accordance with one or more embodiments of the present disclosure. Similar to device 100, the LIP device 200 includes a stack 206 comprising a plurality of metal layers having dielectric material therebetween. The metal layers include a first metal layer 210. This metal layer 210 is remote from a first major, or bottom, surface 202 of the LIP device and acts as a reflecting layer for the launcher. In the launcher region 204, the metal layer is generally planar and continuous - that is to say, it typically does not have large apertures or gaps therein, although ,as the skilled person will appreciate, it may include small (relative to the wavelength of the RF signals), "de-gassing" holes, or be otherwise similarly patterned. Another metal layer 220 (which may also be referred to as a third metal layer) is at or adjacent the first major surface, 202 of the LIP device 200. This metal layer includes an aperture 222 in the launcher region 204. Elsewhere the layer may be patterned in order to provide various electrical contacts to the solder balls 170, as shown, from either a semiconductor die (in the case that the LIP device is part of a packaged semiconductor device) or from a packaged semiconductor device such as a BGA packaged device (in the case that the LIP device is a substrate onto which the packaged semiconductor device is to be affixed), as will be discussed in more detail hereinbelow, with reference to FIG.s 12 and 13. Within the aperture 222 is provided an antenna 225. As, again, will be discussed in more detail hereinbelow, the antenna may be a slot antenna; however, alternatively without limitation the antenna may take a different form, for example, it might be a single-ended patch or a dipole antenna.

Between the backing reflector layer 210 and the third metal layer 220 including the antenna 225 therein, is a further metal layer 230 (which may also be referred to as a second metal layer). This metal layer is discontinuous, and in particular in the launcher region 204, it includes an array of isolated metal patches 232. As will be discussed in more detail hereinbelow, the isolated metal patches 232 form an array which may conveniently be a rectangular or rectilinear array, although other geometries such as a hexagonal array are not excluded.

Further, there may be one or more further metal layers also between the backing reflector layer 210 and the third metal layer 220. In embodiments such as that shown in FIG. 2, there is one such further metal layer 240. In the launcher region 204, the further metal layer also includes a plurality of isolated metal patches 242 forming an array. Between the patches is an insulating material, which may, as shown be the dielectric material, 150, although in other embodiments, this insulating material may be a different material, for example, an adhesive material.

The one or more layers of metal including isolated patches 232 and 242 within the launcher region 204 may be beneficial in either or both of at least two ways. Firstly, the presence of the metal within the launcher cavity region stratifies or reduces the volume of dielectric material in the region, and thus reduces the tendency for shrinkage of that material, which may otherwise occur, in particular, but not limited to the case where the dielectric is an encapsulant. This may assist in improving the planarity of the backing reflector layer 210. A further advantage may be observable in particular where there are two or more such isolated patch arrays 232 and 242: the arrays may act to provide a so-called "artificial dielectric layer" (ADL) in the launcher cavity region. Such an ADL may increase an effective dielectric constant of the cavity viewed as a whole, which may result in improved or increased design flexibility and/or RF performance, as will be discussed in more detail hereinbelow, with reference to FIG.s 10 and 11.

Outside of the launcher region 204, the second metal layer 230 and any or each of the further metal layers 240 may be continuous or patterned as required. In particular, one or more of the layers may be patterned in order to provide an RF feed-path 235, along with one or more vias 265 to the antenna, 225. The skilled person will appreciate that the in order to provide an RF signal path to the antenna, the vias and part of the feet-path may extend into the launcher region 204.

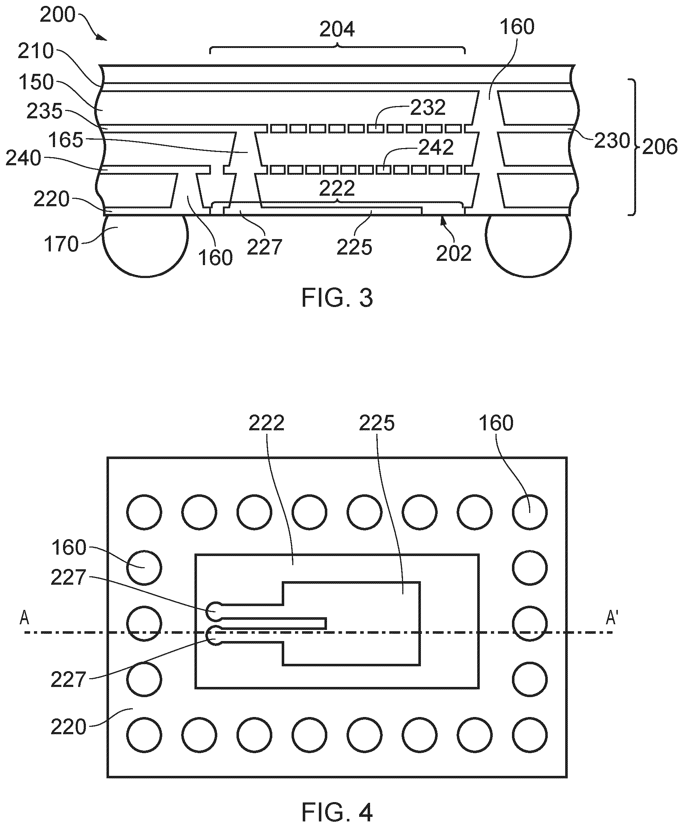

Turning now to FIG.s 3 and 4, these show, in more detail, a schematic section through an LIP device 200 in FIG. 3, which corresponds to a section AA' in the bottom view, shown in FIG. 4. It will be appreciated that, for the purposes of clarity, the solder balls 170 in FIG. 3 are not shown in the bottom view of FIG. 4.

The LIP device 200 of FIG. 3 is the same as that shown in FIG. 2, and includes the first, backing reflector, metal layer 210, along with the second metal layer 230 having an array of metal patches 232 within the launcher region 204, and the third metal layer 220 which includes the antenna 225 within an aperture 222 which broadly corresponds to the launcher region 204. In the embodiment depicted in FIG. 3, there is also one further metal layer 240, which also includes an array of metal patches 242 within the launcher region 204. The metal layers are separated by dielectric material, which for instance may be an encapsulant, or a PCB material such as FR4. In the latter case, the LIP device may be constructed by pressing together a stack of circuit boards, or PCBs, each of which may have metal tracks, for example of copper, on one or both sides. In this case, there may be included an adhesive material in order to bond the PCBs together. The adhesive material may flow or reflow to fill in the gaps between the individual metal patches 232 and 242. In embodiments in which the dielectric is an encapsulant, encapsulant may reflow around and/or between the metal patches 232 and 242.

FIG. 4 shows a bottom view, that is to say, a view looking up at the first major surface 202, relative to FIG. 3. The FIG. shows the third metal layer 220, including the aperture 222 therein. Within the aperture is an antenna, which in this case is a slot antenna. The slot antenna is fed by at feed points 227 at the end of feed lines, which are connected by means of conductive vias 165 to one of the intermediate metal layers, in this case metal layer 230, which includes patterning to provide the RF feed-path 235, as can be seen in FIG. 3. FIG. 4 also shows, schematically, conductive vias 160, which provide an electromagnetic "fence" around the launcher region. The skilled person will appreciate that, in case of LIP devices constructed of a stack of PCBs, the conductive wires are formed by metallised holes through the circuit board; alternatively, in the case that the LIP device is part of a packaged semiconductor die, the vias may be formed by metal (or other conductive material) pillars or posts which protrude through the individual encapsulant layers, in order to provide interconnections between metal layers.

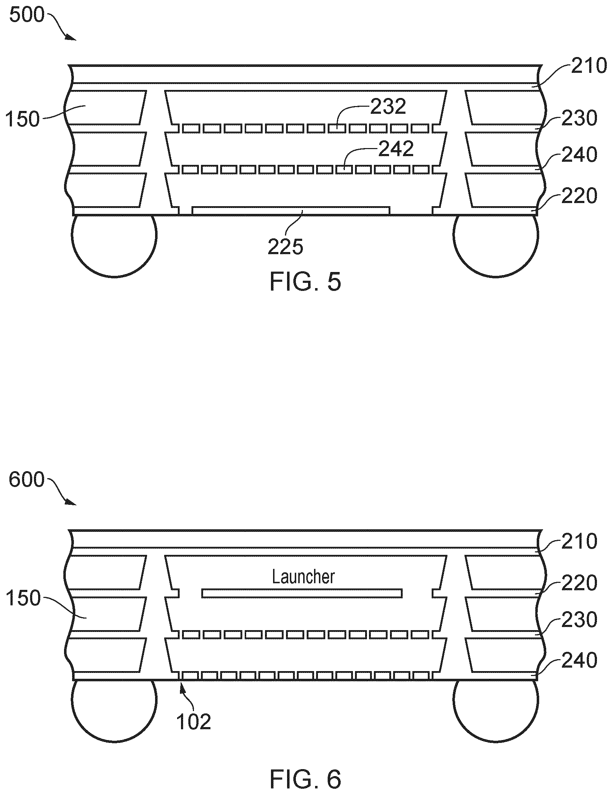

Turning to FIG. 5, this shows a schematic section through another LIP device 500 according to one or more embodiments. The LIP device 500 may be the same as LIP device 200 shown in FIG. 2, but viewed through a different section, such that the RF feed-path to the antenna or launcher 225 is not visible in this section.

FIG. 6 shows a schematic section through another LIP device 600, according to one or more other embodiments. This device differs from that shown in FIG. 5, in that the metal layers are arranged in a different order, considered in a vertical direction. In embodiments such as that shown in FIG. 6, the launch antenna is not positioned at or proximate to the first major surface 102 of the LLP device. Instead, the launch antenna is positioned above the second metal layer and the or each further metal layers, which in combination form the artificial dielectric layer ADL (when viewed from the side such that the RF signal is to be launched into a waveguide below the device). That is to say, the RF signal launched from the antenna 225 passes through the dielectric 150 and the artificial dielectric layer formed by the discontinuous metal layers 232 and 242 prior to exiting the device from the first major surface. It will be appreciated that in this configuration, a larger proportion of power is radiated downwards, reducing the reactive impact of the reflector on the impedance which may be beneficial to improve the impedance-matching bandwidth.

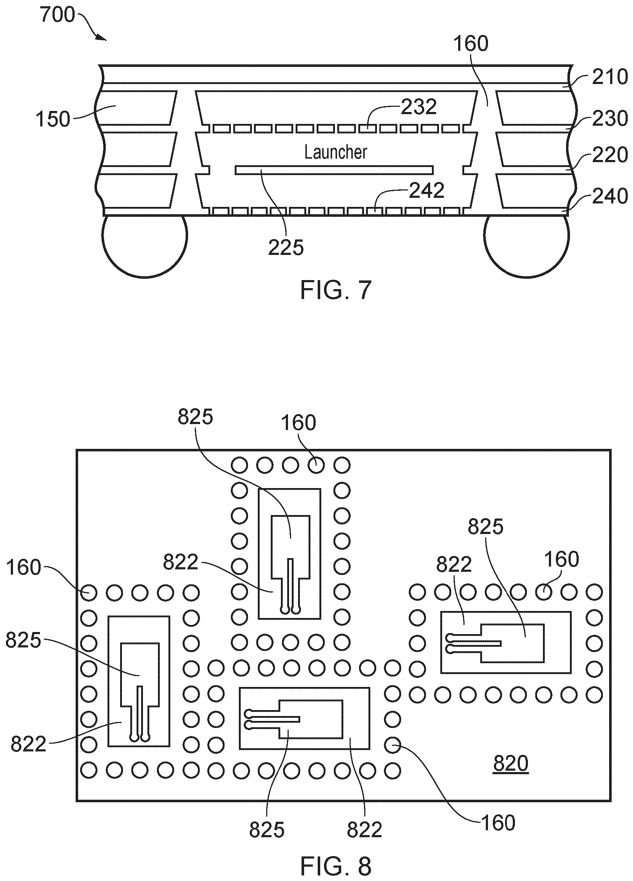

FIG. 7 shows a schematic section through another LIP device 700, according to one or more yet further embodiments. In this configuration, the third metal layer 220, with the antenna therein, is located between two (or more) second and further metal layers 230 and 240, which each include an array of metal patches and which form the ADL. This configuration may help to reduce the overall strain in the device, since arrays of isolated metal patches are more evenly distributed throughout the device.

Turning to FIG. 8, this shows a schematic bottom view of an LIP device according to one or more other embodiments. In embodiments such as that shown, multiple antennas 825 (in this case four) are positioned within respective apertures 822 in the metal layer 820. As shown, the metal layer may be proximate to the first major surface of the device; however the skilled person will appreciate that other configurations of layers may be used, such as that shown above in FIG. 6 and 7. Each of the launcher regions and apertures 822 may be surrounded, as shown, by a "fence" of vias 160 to provide electromagnetic isolation for the respective RF signals. The arrangement shown in FIG. 8 may be particularly useful for applications such as automotive radar devices in which a single package semiconductor die (such as a BGA packaged die) may require to transmit radar signals from 2 or more transmitters or transmit antennas, and receive reflections of the transmitted signals, at two or more receivers or receive antennas.

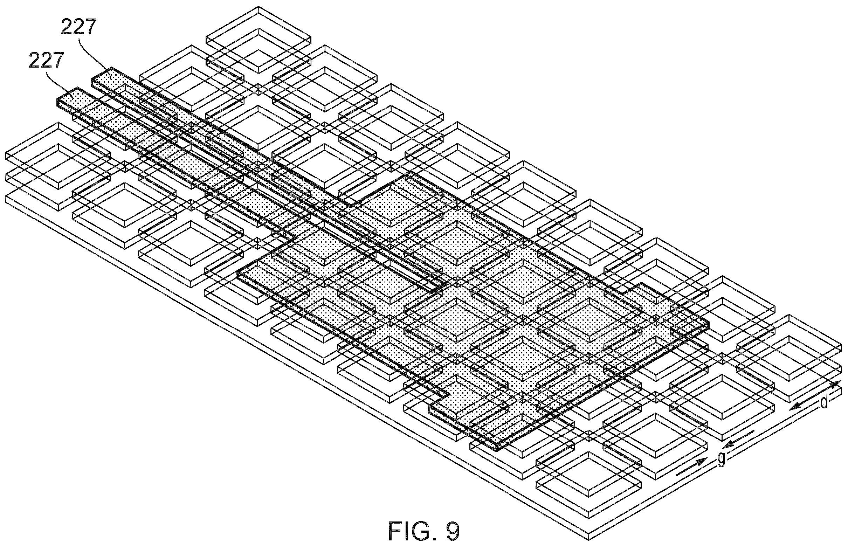

Turning to FIG. 9, this shows a perspective view of four metal layers in a launch region of an LIP device. It will be appreciated that the figure is substantially inverted with respect to the sections shown in FIG. 2, 3 and 5. The FIG. shows the antenna 225 (in this case a patch antenna fed by a differential feed line ending at feed points 227 within an aperture 222 (not shown in figure 9) in the third metal layer 220. It will be appreciated since only the launch region of the device is shown, the remainder of the metal layer 220, bounding the aperture, is not visible. The FIG. also shows the second metal layer 230 and in one or more further metal layers (which, as shown may be a single further metal layer 240); in the launch region each of the second metal layer and the one or more further metal layers has a patterned form, which in this example case is a regular array of square metal patches having gaps therebetween. Finally, the figure shows the first metal layer 210, which is part of a continuous metal layer, and comprises, in the launch region, the backing reflector layer.

In the example shown in FIG. 9, the patches of both the second metal layer 230 and the further metal layer 240 are square, having a dimension g and the gap g therebetween. The dimension d is typically less than or equal to ¼ of the wavelength of the RF signal, that is to say d ≤ λ/4, and the gaps between the patches are smaller than the patches themselves, in order that the layers are partially transparent to the RF signal and act as an artificial dielectric layer (ADL). As a nonlimiting example, for a 80 GHz radar system, for which the free-space wavelength λ is approximately 3.5mm, the patches may typically have a dimension d of approximately 200µm and the gaps g may have a value for example of 50µm. The spacing s between the layers is typically smaller than the patches, and for example typically s ≤ λ/10; in some devices s may be 25-150µm.

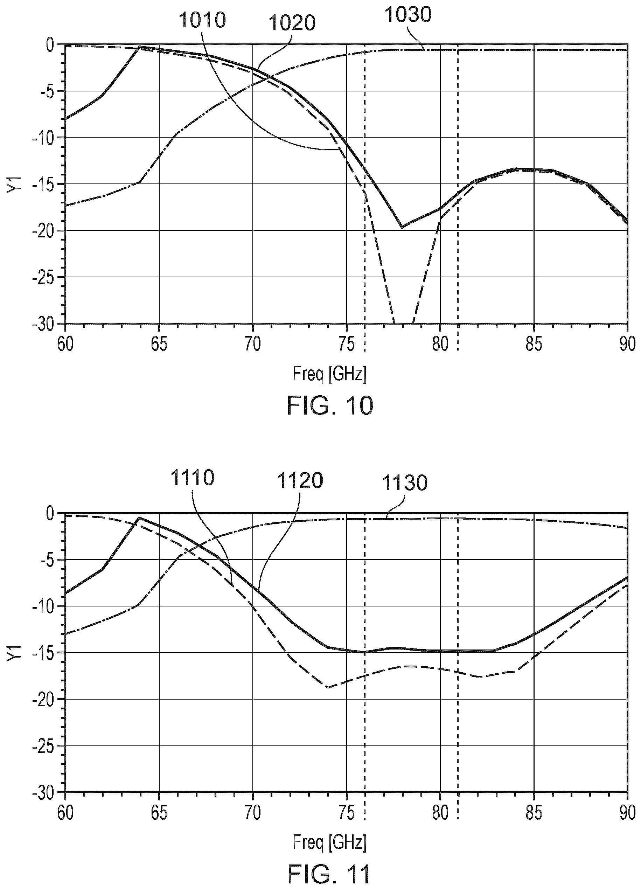

Turning now to FIG.s 10 and 11, these show simulated millimeter-wave performance of, at FIG. 10, a conventional LIP device without patches, and at FIG. 11, an LIP device, including patches, according to an embodiment of the present disclosure. The figures show, plotted against frequency on the x-axis, at 1010 and 1110 the magnitude of the reflection coefficient (in dB) of the waveguide launcher seen from the differential line, at 1020 and 1120 the magnitude of the reflection coefficient (in dB) of the waveguide launcher seen from the air-filled waveguide side, and at 1030 and 1130 the insertion loss (in dB) of the launcher between differential line and waveguide. As can be seen by comparing the two figures, the LIP device having patches in the intermediate layers forming an ADL shows improved performance, in that the passband is more centred around the target Raider frequency band (of 76 to 81 GHz. The band is also wider, since the matching frequency (at -10 dB) is shifted downwards from 75 GHz in the conventional device to 71 GHz in the device, including patches. In this example, simulation, the patches are square with a dimension of 200 µm, separated by 50 µm gaps, in each of two metal layers intermediates the antenna and backing reflector layer.

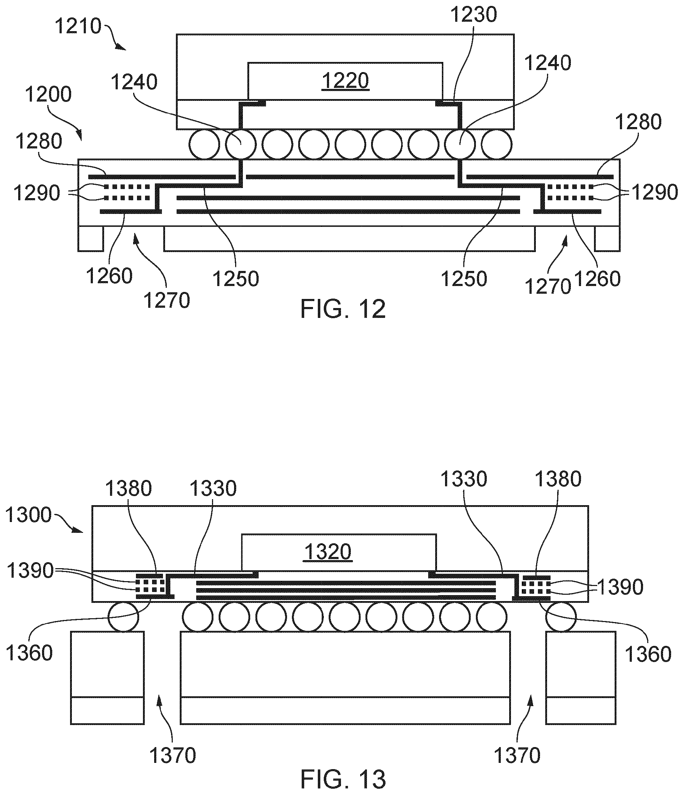

Turning now to FIG. 12 and FIG. 13, these show two types of implementations of LIP devices, according to one or more embodiments of the present disclosure. In FIG. 12, an LIP device 1200 is provided as a substrate, onto which is mounted a BGA packaged semiconductor device 1210. RF signals are rooted to and from a semiconductor die 1220 through microstrip, or stripline 1230, and solder balls 1240 forming part of the BGA array. Within the LIP device 1200. Feed lines 1250 guide the RF signal to (or from) the launch antennas 1260, which launch the signal into the waveguide regions 1270. Between the launch antennas 1260 and a backing reflector metal layer 1280 are positions one or more (in this case two), intermediate metal layers 1290 having therein isolated metal patches forming an array. In the embodiment shown in FIG. 13, the LIP device is, or forms part of, a redistribution structure in a BGA packaged semiconductor device 1300. In this embodiment, the RF signal is routed to or from a semiconductor die 1320, through feed lines which form a feed-path 1330, to one or more launch antennas (as shown, there are two) 1360, which is (or are) configured to launch the RF signal (or signals) into AFWG regions 1370. Once again there are intermediate metal layers 1390 having a discontinuous array of isolated metal patches in the launch regions, and between the launch antenna 1360 and a backing reflector layer 1380.

The illustrations of embodiments described herein are intended to provide a general understanding of the structure of various embodiments, and they are not intended to serve as a complete description of all the elements and features of apparatus and systems that might make use of the structures described herein. Many other embodiments will be apparent to those of skill in the art upon reviewing the above description. Other embodiments may be utilized and derived therefrom, such that structural and logical substitutions and changes may be made without departing from the scope of this disclosure. Figures are also merely representational and may not be drawn to scale. Certain proportions thereof may be exaggerated, while others may be minimized. Accordingly, the specification and drawings are to be regarded in an illustrative rather than a restrictive sense.

Although specific embodiments have been illustrated and described herein, it should be appreciated that any arrangement calculated or constructed to achieve the same or a similar purpose may be substituted for the specific embodiments shown. This disclosure is intended to cover any and all adaptations or variations of various embodiments. Combinations of the above embodiments, and other embodiments not specifically described herein, are contemplated by the subject disclosure.

For instance, one or more features or aspects from one or more embodiments can be combined with one or more features or aspects of one or more other embodiments. In one or more embodiments, features that are positively recited can also be negatively recited and excluded from the embodiment with or without replacement by another structural and/or functional feature. The steps or functions described with respect to the embodiments of the subject disclosure can be performed in any order. The steps or functions described with respect to the embodiments of the subject disclosure can be performed alone or in combination with other steps or functions of the subject disclosure, as well as from other embodiments or from other steps that have not been described in the subject disclosure. Further, more than or less than all of the features described with respect to an embodiment can also be utilized.

Less than all of the steps or functions described with respect to the exemplary processes or methods can also be performed in one or more of the exemplary embodiments. Further, the use of numerical terms to describe a device, component, step or function, such as first, second, third, and so forth, is not intended to describe an order or function unless expressly stated so. The use of the terms first, second, third and so forth, is generally to distinguish between devices, components, steps or functions unless expressly stated otherwise. Additionally, one or more devices or components described with respect to the exemplary embodiments can facilitate one or more functions, where the facilitating (e.g., facilitating access or facilitating establishing a connection) can include less than every step needed to perform the function or can include all of the steps needed to perform the function.

The Abstract of the Disclosure is provided with the understanding that it will not be used to interpret or limit the scope or meaning of the claims. In addition, in the foregoing Detailed Description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus the following claims are hereby incorporated into the Detailed Description, with each claim standing on its own as a separately claimed subject matter.

### LIST OF REFERENCE SIGNS

- 100: LIP device
- 102: first major surface
- 104: launcher region
- 106: stack
- 108: major surface
- 110: metal layer
- 115: backing reflector layer
- 120: metal
- 125: antenna
- 128: wavelets
- 130: intermediate metal layers
- 135: strip line
- 140: intermediate metal layers
- 150: dielectric material
- 155: cavity region
- 160: conductive vias
- 165: vias
- 170: solder balls
- 180: waveguide structure
- 185: side faces
- 190: cavity waveguide
- 200: LIP device
- 202: surface
- 204: launcher region
- 206: stack
- 210: backing reflector layer
- 220: third metal layer
- 222: aperture
- 225: antenna
- 230: second metal layer
- 232: metal patches
- 235: RF feed - path
- 240: metal layer
- 242: metal patches
- 265: vias
- 500: LIP device
- 820: metal layer
- 822: apertures
- 825: antennas
- 1010: reflection coefficient, seen from the differential line
- 1020: reflection coefficient, seen from the AFWG
- 1030: insertion loss, between the differential line and AFWG
- 1110: reflection coefficient, seen from the differential line
- 1120: reflection coefficient, seen from the AFWG
- 1130: insertion loss, between the differential line and AFWG
- 1200: LIP device
- 1210: BGA packaged semiconductor device
- 1220: semiconductor die
- 1230: stripline
- 1240: solder balls
- 1250: feed lines
- 1260: antennas
- 1270: waveguide regions
- 1280: backing reflector metal layer
- 1290: intermediate metal layers
- 1300: BGA packaged semiconductor device
- 1320: semiconductor die
- 1330: feed-path
- 1360: antenna
- 1370: AFWG regions
- 1380: backing reflector layer
- 1390: intermediate metal layers

## Claims

1. A launcher-in-package, LIP, device, adapted to launch an RF signal from a first major surface thereof and comprising:
a stack including a plurality of metal layers having dielectric material therebetween;
wherein the plurality of metal layers comprises, in a launcher region:
a first planar metal layer comprising a continuous layer configured as a backing reflector layer;
a second planar metal layer being discontinuous and comprising a plurality of isolated metal patches in an array and having insulating material therebetween; and
a third planar metal layer having an aperture therein, and a patterned metal antenna within the aperture and configured for launching the RF signal;
wherein the first planar metal layer is more remote from the first major surface than each of the second planar metal layer and the discontinuous metal layer;
and an RF feed-path to the patterned metal antenna.

2. The LIP device of claim 1, further comprising:
one or more further planar metal layers, each being discontinuous and comprising a further plurality of isolated metal patches in an array and having dielectric material therebetween.

3. The LIP device of claim 1 or 2, wherein:
the third planar layer is at the first major surface of the LIP device package; and
the second planar layer, and when dependant on claim 2 the or each of the second of the further planar metal layers, is between the first planar layer the third planar layer.

4. The LIP device of any preceding claim, wherein:
the isolated metal patches, and when dependant on claim 2 the or each of the second of the further isolated metal patches have a larger dimension which is not more than λ/4, where λ is a wavelength of the RF signal.

5. The LIP device of any preceding claim, wherein:
the isolated metal patches, and when dependant on claim 2 the or each of the second of the further isolated metal patches, are rectangular.

6. The LIP device of claim 2, or any claim depending therefrom, wherein:
each respective patch in the second planar metal layer is aligned with a respective patch in the or each further planar metal layers.

7. The LIP device of any preceding claim, wherein:
the array has a respective pitch, in each of an x-direction and a y-direction, each within a range of 175µm to 250µm.

8. The LIP device of any preceding claim, wherein:
the stack further comprises, surrounding the launcher region, a plurality of conductive vias through the dielectric layers, and providing electrical connection between the metal layers and RF shielding for the launcher.

9. The LIP device of any preceding claim, wherein:
the patterned metal antenna comprises a patch antenna.

10. The LIP device of any preceding claim, wherein:
the device is a ball-grid-array, BGA, package;
the dielectric material and the insulating material is an encapsulant material;
the stack forms a redistribution structure;
the RF feed-path provides an electrical connection between the launcher and a semiconductor die within the BGA package.

11. The LIP device of claim 10,
adapted to launch an RF signal from the first major surface thereof into an air-filled waveguide, AFWG.

12. An LIP assembly, comprising:
the LIP device of claim 11, and
the AFWG.

13. The LIP device of any of claims 1 to 9, wherein:
the device forms a substrate, to which a ball-grid-array, BGA, package may be affixed on a surface opposite the first major surface;
the stack is formed of a plurality of printed circuit boards, PCBs, wherein the insulating material is an adhesive material for bonding the PCBs; and
the RF feed-path provides electrical connection between the launcher and a contact for connection to a solder ball of the BGA package.

14. The LIP device of any of any preceding claim, wherein:
in the launcher region, the first planar metal layer has no apertures therethrough which are larger than λ/4, where λ is a or the wavelength of the RF signal.

## Amended claims

### Amended claims in accordance with Rule 137(2) EPC.

1. A launcher-in-package, LIP, device (200), adapted to launch an RF signal from a first major surface (202) thereof and comprising:
a stack (206) including a plurality of metal layers having dielectric material therebetween;
wherein the plurality of metal layers comprises, in a launcher region:
a first planar metal layer (210) comprising a continuous layer configured as a backing reflector layer;
a second planar metal layer (230) being discontinuous and comprising a plurality of isolated metal patches (232) in an array and having insulating material therebetween; and
a third planar metal layer (220) having an aperture therein, and a patterned metal antenna within the aperture and configured for launching the RF signal;
wherein the first planar metal layer is more remote from the first major surface than each of the second planar metal layer and the discontinuous metal layer;
and an RF feed-path (235) to the patterned metal antenna.

2. The LIP device of claim 1, further comprising:
one or more further planar metal layers (240), each being discontinuous and comprising a further plurality of isolated metal patches in an array and having dielectric material therebetween.

3. The LIP device of claim 1or 2, wherein:
the third planar layer is at the first major surface of the LIP device package; and
the second planar layer, and when dependant on claim 2 the or each of the second of the further planar metal layers, is between the first planar layer the third planar layer.

4. The LIP device of any preceding claim, wherein:
the isolated metal patches, and when dependant on claim 2 the or each of the second of the further isolated metal patches have a larger dimension which is not more than A/4, where λ is a wavelength of the RF signal.

5. The LIP device of any preceding claim, wherein:
the isolated metal patches, and when dependant on claim 2 the or each of the further isolated metal patches, are rectangular.

6. The LIP device of claim 2, or any claim depending therefrom, wherein:
each respective patch in the second planar metal layer is aligned with a respective patch in the or each further planar metal layers.

7. The LIP device of any preceding claim, wherein:
the array has a respective pitch, in each of an x-direction and a y-direction, each within a range of 175µm to 250µm.

8. The LIP device of any preceding claim, wherein:
the stack further comprises, surrounding the launcher region, a plurality of conductive vias, through the dielectric layers and configured to provide electrical connection between the metal layers and RF shielding for the launcher.

9. The LIP device of any preceding claim, wherein:
the patterned metal antenna comprises a patch antenna.

10. The LIP device of any preceding claim, wherein:
the device is a ball-grid-array, BGA, package;
the dielectric material and the insulating material is an encapsulant material;
the stack forms a redistribution structure;
the RF feed-path provides an electrical connection between the launcher and a semiconductor die within the BGA package.

11. The LIP device of claim 10,
adapted to launch an RF signal from the first major surface thereof into an air-filled waveguide, AFWG.

12. An LIP assembly, comprising:
the LIP device of claim 11, and
the AFWG.

13. The LIP device of any of claims 1 to 9, wherein:
the device forms a substrate, to which a ball-grid-array, BGA, package may be affixed on a surface opposite the first major surface;
the stack is formed of a plurality of printed circuit boards, PCBs, wherein the insulating material is an adhesive material for bonding the PCBs; and
the RF feed-path provides electrical connection between the launcher and a contact for connection to a solder ball of the BGA package.

14. The LIP device of any of any preceding claim, wherein:
in the launcher region, the first planar metal layer has no apertures therethrough which are larger than λ/4, where λ is a or the wavelength of the RF signal.
